# FASCICULE DE BREVET EUROPEEN

(11) **EP 2 963 506 B1**
(45) Date de publication et mention de la délivrance du brevet: **20.03.2019**
(21) Numéro de dépôt: 15160588.8
(22) Date de dépôt: 24.03.2015
(51) Int. Cl.: G04C 10/02, G09F 9/30, G02F 1/1335

(54) **ENSEMBLE D'AFFICHAGE COMPRENANT DEUX DISPOSITIFS D'AFFICHAGE SUPERPOSÉS**
ANZEIGEEINHEIT, DIE ZWEI ÜBEREINANDERGELAGERTE ANZEIGEVORRICHTUNGEN UMFASST
DISPLAY ASSEMBLY INCLUDING TWO STACKED DISPLAY DEVICES

(30) Priorité: 04.07.2014 EP 14175864; 20.08.2014 EP 14181607
(43) Date de publication de la demande: 06.01.2016
(73) Titulaire: The Swatch Group Research and Development Ltd., 2074 Marin (CH)
(72) Inventeur: Sagardoyburu, Michel, 2000 Neuchâtel (CH)
(74) Mandataire: Supper, Marc

(56) Documents cités:
- EP-A1- 1 004 924
- EP-A1- 2 148 381
- WO-A1-2013/115043
- WO-A2-02/29484
- US-A- 6 147 934
- US-A1- 2011 128 264
- US-B1- 6 462 805

## Description

### Domaine de l'invention

La présente invention concerne un ensemble d'affichage comprenant deux dispositifs d'affichage superposés. Plus précisément, la présente invention concerne un tel ensemble d'affichage destiné à être logé dans un objet portable tel qu'une montre-bracelet.

### Arrière-plan technologique de l'invention

La lisibilité des informations affichées par les dispositifs d'affichage digitaux actifs tels que les dispositifs d'affichage à cristaux liquides ou bien les dispositifs d'affichage à diodes organiques électroluminescentes est très dépendante des conditions de luminosité ambiante. Avec certains dispositifs d'affichage digitaux, les informations affichées peuvent être lues dans de bonnes conditions dans un environnement fortement éclairé, mais sont par contre difficiles à lire dans un environnement sombre. Inversement, d'autres catégories de dispositifs d'affichage digitaux fournissent un affichage de bonne qualité dans le noir ou la pénombre, mais sont quasiment inutilisables en plein jour.

A titre d'exemple, considérons les cellules d'affichage à cristal liquide de type transflectif, c'est-à-dire des cellules à cristal liquide capables d'afficher des informations qui vont être visibles en plein soleil grâce à un phénomène de réflexion, et qui vont être également visibles dans le noir par transmission en utilisant un dispositif de rétroéclairage. De telles cellules d'affichage à cristal liquide de type transflectif sont optimisées pour pouvoir réfléchir au mieux la lumière du soleil et ainsi garantir une bonne lisibilité des informations affichées dans des conditions de forte luminosité. Cependant, afin que de telles cellules d'affichage à cristal liquide de type transflectif puissent réfléchir au mieux la lumière du soleil, leur efficacité en transmission est fortement limitée. Ainsi, lorsque le dispositif de rétroéclairage est activé afin de permettre de lire les informations affichées dans la pénombre, une majeure partie de la lumière générée par le dispositif de rétroéclairage se perd dans des phénomènes d'absorption. Le rendement énergétique est donc mauvais. En outre, les qualités optiques des informations affichées par la cellule à cristal liquide sont fortement dépendantes de l'angle de vue.

En ce qui concerne les dispositifs d'affichage de type émissif tels que les dispositifs d'affichage à diodes organiques électroluminescentes, ils présentent des qualités optiques qui sont supérieures à celles des cellules d'affichage à cristal liquide, ces qualités optiques ne dépendant notamment pas de l'angle de vue. Néanmoins, ces dispositifs d'affichage de type émissif de haute qualité ne permettent pas un fonctionnement en mode réflectif. Les informations qu'ils affichent sont donc très lisibles en intérieur et dans le noir, mais deviennent difficilement lisibles dès qu'elles sont observées en extérieur. Pour remédier à ce problème, il est nécessaire d'augmenter la quantité de courant fournie aux dispositifs d'affichage émissifs afin de garantir un minimum de lisibilité. De plus, même en conditions d'utilisation normales, ces dispositifs d'affichage émissifs consomment davantage de courant électrique qu'une cellule d'affichage à cristal liquide de type réflectif. Leur consommation électrique est telle qu'il n'est pas possible de les conserver allumés en permanence, par exemple dans une montre dont la seule source d'énergie est une pile dont on souhaite qu'elle dure au moins un an. Le document US2011/0128264 décrit un afficheur transflectif utilisant la combinaison d'un écran émissif et d'un couche à cristaux liquides.

### Résumé de l'invention

La présente invention a pour but de remédier aux problèmes susmentionnés ainsi qu'à d'autres encore en procurant un ensemble d'affichage pour un objet portable tel qu'une montre-bracelet dont le fonctionnement soit convenable aussi bien dans un environnement fortement éclairé que dans un environnement sombre.

A cet effet, la présente invention concerne un ensemble d'affichage pour un objet portable, cet ensemble d'affichage comprenant un premier dispositif d'affichage réflectif situé du côté d'un observateur, ce premier dispositif d'affichage étant capable de commuter entre un état transparent lorsqu'il est au repos et un état réflectif lorsqu'il est activé, un second dispositif d'affichage émissif étant disposé sous le premier dispositif d'affichage réflectif.

Selon une caractéristique complémentaire de l'invention, le dispositif d'affichage réflectif est collé sur le dispositif d'affichage émissif.

Selon une autre caractéristique de l'invention, le dispositif d'affichage réflectif est collé sur le dispositif d'affichage émissif au moyen d'un adhésif en film ou d'une couche de colle liquide.

Grâce à ces caractéristiques, la présente invention procure un ensemble d'affichage pour un objet portable tel qu'une montre-bracelet dont le fonctionnement est optimal quelles que soient les conditions d'éclairement ambiant. En plein jour, les informations seront préférentiellement affichées par le dispositif d'affichage réflectif. En effet, ce dispositif d'affichage réflectif, utilisant la lumière du soleil pour afficher les informations, est économe en énergie. Il peut donc rester allumé en permanence et offre une bonne lisibilité des informations. Inversement, dans la pénombre ou l'obscurité, les informations seront affichées par le dispositif d'affichage émissif. Un tel dispositif d'affichage émissif consomme davantage de courant qu'un dispositif d'affichage réflectif, mais les informations qu'il affiche sont visibles de nuit ou dans l'obscurité avec de très bonnes propriétés optiques qui sont notamment indépendantes de l'angle de vue.

Selon une première variante de réalisation de l'invention, le premier dispositif d'affichage comprend une cellule d'affichage à cristal liquide réflective, et le second dispositif d'affichage comprend une cellule d'affichage émissive à diodes organiques électroluminescentes.

Selon une seconde variante de réalisation de l'invention, le premier dispositif d'affichage comprend une cellule d'affichage à cristal liquide réflective, et le second dispositif d'affichage comprend une cellule d'affichage à cristal liquide transmissive sous laquelle est disposé un dispositif de rétroéclairage.

Grâce à ces autres caractéristiques, la présente invention procure un ensemble d'affichage qui permet d'afficher en permanence des informations de manière simple et lisible, tout en consommant peu d'énergie électrique. En particulier, la présente invention procure un ensemble d'affichage permettant d'afficher un grand nombre d'informations qui sont visibles même dans l'obscurité.

### Brève description des figures

D'autres caractéristiques et avantages de la présente invention ressortiront plus clairement de la description détaillée qui suit de plusieurs exemples de réalisation de l'ensemble d'affichage selon l'invention, ces exemples étant donnés à titre purement illustratif et non limitatif seulement, en liaison avec le dessin annexé sur lequel :
- la figure 1 est une vue en coupe d'un premier mode de réalisation d'un ensemble d'affichage selon l'invention qui comprend une cellule d'affichage à cristal liquide de type réflectif collée sur une cellule d'affichage à diodes organiques électroluminescentes ;
- les figures 2A à 2D illustrent schématiquement le mode de fonctionnement de l'ensemble d'affichage illustré à la figure 1 selon que la cellule d'affichage à cristal liquide et la cellule d'affichage à diodes organiques électroluminescentes sont actives ou passives ;
- la figure 3 est une vue en coupe d'une variante de réalisation de l'ensemble d'affichage selon l'invention illustré à la figure 1 dans laquelle une cellule d'affichage à cristal liquide à simple polariseur est collée sur une cellule d'affichage à diodes organiques électroluminescentes ;
- les figures 4A à 4D illustrent schématiquement le mode de fonctionnement de l'ensemble d'affichage représenté à la figure 3 selon que la cellule d'affichage à cristal liquide à simple polariseur et la cellule d'affichage à diodes organiques électroluminescentes sont actives ou passives, et
- la figure 5 est une vue en coupe d'un second mode de réalisation d'un ensemble d'affichage selon l'invention qui comprend une cellule d'affichage à cristal liquide réflective collée sur une cellule d'affichage à cristal liquide transmissive rétroéclairée.

### Description détaillée d'un mode de réalisation de l'invention

La présente invention procède de l'idée générale inventive qui consiste à procurer un ensemble d'affichage qui soit capable d'afficher de manière lisible des informations à la fois en plein jour et dans la pénombre ou l'obscurité et dont la consommation d'énergie électrique est optimale. Pour atteindre cet objectif, la présente invention enseigne de combiner un dispositif d'affichage qui est agencé pour pouvoir commuter entre un état de repos dans lequel il est transparent et un état actif dans lequel il est capable de réfléchir la lumière ambiante avec un dispositif d'affichage de type émissif. Le dispositif d'affichage de type réflectif est typiquement une cellule d'affichage à cristal liquide, tandis que le dispositif d'affichage de type émissif est typiquement une cellule d'affichage à diodes organiques électroluminescentes ou bien une cellule d'affichage à cristal liquide transmissive à laquelle est associé un dispositif de rétroéclairage. Pour l'affichage des informations en plein jour, on privilégie l'utilisation du dispositif d'affichage de type réflectif qui, par réflexion de la lumière du soleil, permet d'afficher les informations de manière claire et lisible tout en consommant peu d'énergie électrique. Pour l'affichage des informations dans la pénombre ou l'obscurité, on privilégie l'utilisation du dispositif d'affichage émissif. Grâce à ses excellentes propriétés optiques, notamment en termes de contraste et de reproduction des couleurs, un tel dispositif d'affichage émissif permet d'afficher un grand nombre d'informations de manière très lisible. En particulier, la lisibilité des informations affichées n'est pas dépendante de l'angle de vue. De plus, malgré la pénombre ou l'obscurité, il est possible de réduire de manière significative la consommation d'énergie d'un tel dispositif d'affichage émissif tout en garantissant une bonne lisibilité des informations affichées. On dispose ainsi d'un ensemble d'affichage qui comprend un dispositif d'affichage réflectif placé sur le dessus de l'empilement et qui est capable d'afficher des informations en permanence en consommant très peu d'énergie, et un dispositif d'affichage émissif placé à la base de l'empilement et qui est capable d'afficher à la demande des informations de manière très lisible dans la pénombre ou l'obscurité.

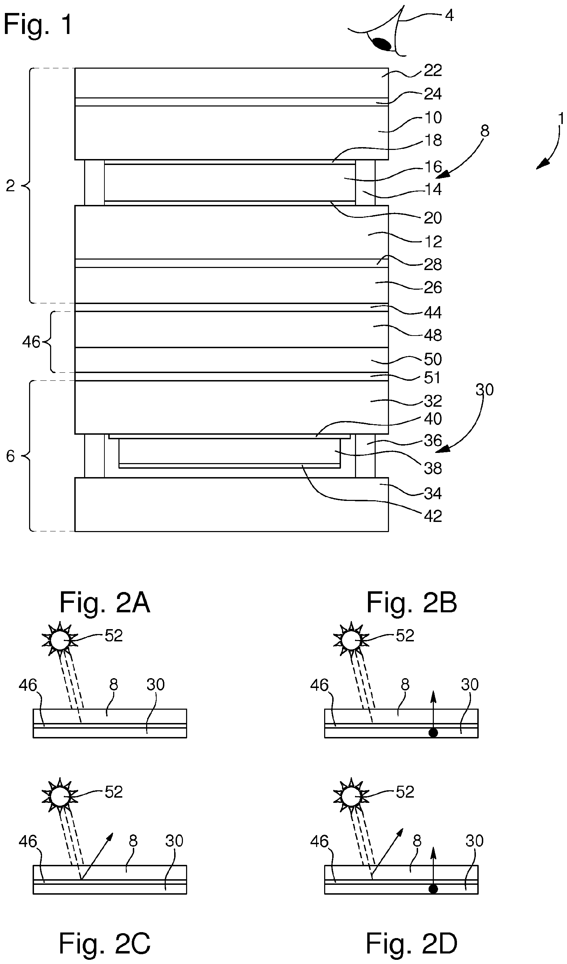

La figure 1 est une vue en coupe d'un premier mode de réalisation d'un ensemble d'affichage selon l'invention. Désigné dans son ensemble par la référence numérique générale 1, cet ensemble d'affichage comprend un premier dispositif d'affichage réflectif 2 situé du côté d'un observateur 4 et un second dispositif d'affichage émissif 6 disposé sous le premier dispositif d'affichage réflectif 2.

Conformément à l'invention, le premier dispositif d'affichage réflectif 2 qui est réflectif dans un premier état de commutation et qui est transparent dans un second état de commutation comprend une cellule d'affichage à cristal liquide 8. Cette cellule d'affichage à cristal liquide 8 comprend, de manière non limitative, un substrat avant 10 situé du côté de l'observateur 4 et un substrat arrière 12 qui s'étend parallèlement à et à distance du substrat avant 10. Ces deux substrats avant 10 et arrière 12 sont réalisés en un matériau transparent tel que du verre ou du plastique. Ces deux substrats avant 10 et arrière 12 sont réunis entre eux par un cadre de scellement 14 qui délimite un volume clos pour le confinement d'un cristal liquide 16 dont les propriétés optiques sont modifiées par application d'une tension appropriée à un point de croisement considéré entre des électrodes transparentes 18 ménagées sur une face inférieure du substrat avant 10 et des contre-électrodes transparentes 20 ménagées sur une face supérieure de substrat arrière 12. Les électrodes 18 et les contre-électrodes 20 sont réalisées en un matériau transparent électriquement conducteur tel que de l'oxyde d'indium-zinc ou de l'oxyde d'indium-étain, ce dernier matériau étant mieux connu sous sa dénomination anglo-saxonne Indium Tin Oxyde ou ITO.

Dans le cas de la présente invention, toutes les phases des cristaux liquides telles que nématique en hélice (Twist Nematic ou TN en terminologie anglo-saxonne), super-nématique en hélice (Super Twist Nematic ou STN en terminologie anglo-saxonne) ou bien encore à alignement vertical (Vertically Aligned ou VA en terminologie anglo-saxonne) peuvent être envisagées. De même, tous les types d'adressage tels qu'adressage direct, adressage par matrice active ou adressage multiplexé d'une matrice passive peuvent être envisagés.

Un polariseur absorbant 22 est collé sur une face supérieure du substrat avant 10 au moyen d'une couche adhésive 24. Cette couche adhésive 24 peut être formée d'un adhésif en film ou d'une couche de colle liquide. La colle utilisée pour solidariser le polariseur absorbant 22 sur la cellule d'affichage à cristal liquide 8 peut-être transparente ou légèrement diffusante selon que l'on cherche à obtenir une réflexion spéculaire, respectivement diffuse. Quant au polariseur absorbant 22, il peut être, par exemple, du type à iodine ou à colorant.

Un polariseur réflectif 26 est collé sur une face inférieure du substrat arrière 12 au moyen d'une couche adhésive 28 qui peut être transparente ou légèrement diffusante selon que l'on cherche à obtenir une réflexion spéculaire, respectivement diffuse. Quant au polariseur réflectif 26, il peut être du type à grille de fils, mieux connu sous sa dénomination anglo-saxonne Wire Grid Polarizer. Il peut également s'agir d'un polariseur composé d'une succession de couches biréfringentes qui provoquent la réflexion ou la transmission de la polarisation par un effet d'interférences constructives ou destructives, comme les polariseurs du type Dual Brightness Enhancement Film (DBEF) ou du type APF commercialisés par la société américaine 3M®.

Toujours selon l'invention, le second dispositif d'affichage émissif 6 comprend une cellule d'affichage émissive 30 à diodes organiques électroluminescentes qui seront désignées ci-après par leur acronyme anglo-saxon OLED (Organic Light Emitting Diode). Cette cellule OLED 30 comprend un substrat 32 transparent réalisé en verre ou en un matériau plastique et un capot d'encapsulation 34 qui s'étend parallèlement à et à distance du substrat 32. Le substrat 32 et le capot d'encapsulation 34 sont réunis entre eux par un cadre de scellement 36 qui délimite un volume clos à l'abri de l'air et de l'humidité pour le confinement d'un empilement de couches électroluminescentes généralement désigné par la référence numérique 38. Une électrode supérieure transparente 40 réalisée par exemple en oxyde d'étain-indium ou ITO et une électrode inférieure réfléchissante 42 réalisée par exemple au moyen d'un matériau tel que de l'aluminium, de l'argent, du calcium ou d'un alliage métallique d'aluminium ou d'argent avec du calcium, du lithium ou du magnésium sont structurées de part et d'autre de l'empilement des couches électroluminescentes 38.

La cellule d'affichage à cristal liquide 8 est, par rapport à l'observateur 4, disposée au-dessus de la cellule OLED 30. De préférence, la cellule d'affichage à cristal liquide 8 est collée sur la cellule OLED 30 au moyen d'une couche adhésive transparente 44 formée d'un adhésif en film ou d'une couche de colle liquide. Il est préférable de coller la cellule d'affichage à cristal liquide 8 sur la cellule OLED 30 afin d'éviter les problèmes de réflexions parasites entre les deux cellules qui dégraderaient la qualité optique de l'ensemble d'affichage 1 selon l'invention.

Entre la cellule d'affichage à cristal liquide 8 et la cellule OLED 30 est intercalé un polariseur circulaire 46 formé d'un polariseur absorbant 48 et d'une lame quart d'onde 50. Ce polariseur circulaire 46 a pour objet d'absorber la lumière ambiante et ainsi donner un aspect noir à la cellule OLED 30 lorsque celle-ci est éteinte. La lame quart d'onde 50 est solidarisée sur le substrat 32 au moyen d'une couche adhésive 51.

Selon une caractéristique complémentaire de l'invention, l'axe de transmission du polariseur réflectif 26 de la cellule d'affichage à cristal liquide 8 est orienté parallèlement à l'axe de transmission du polariseur absorbant 48 appartenant au polariseur circulaire 46 de la cellule d'affichage OLED 30. De cette manière, la lumière émise par la cellule d'affichage OLED 30, polarisée linéairement, passe à travers la cellule d'affichage à cristal liquide 8 lorsque cette cellule d'affichage à cristal liquide 8 se trouve en mode transmissif. Inversement, la lumière ambiante qui arrive dans la cellule d'affichage OLED en passant à travers la cellule d'affichage à cristal liquide 8 est polarisée circulairement par le polariseur circulaire 46. Cette lumière est ensuite réfléchie par l'électrode inférieure réfléchissante 42, ce qui provoque l'inversion du sens de rotation de sa polarisation circulaire et son absorption par le polariseur circulaire 46. L'ensemble d'affichage 1 selon l'invention apparaît ainsi noir au regard de l'observateur 4.

Les figures 2A à 2D illustrent schématiquement le mode de fonctionnement de l'ensemble d'affichage 1 conforme à l'invention selon que la cellule d'affichage à cristal liquide 8 ou la cellule d'affichage OLED 30 est en service ou hors-service. Dans ce qui suit, on supposera que la cellule d'affichage à cristal liquide 8 est une cellule nématique en hélice. Cet exemple est donné à titre purement illustratif et non limitatif seulement dans la mesure où il est plus aisé de décrire le fonctionnement de l'ensemble d'affichage 1 selon l'invention dans le cas où la cellule d'affichage à cristal liquide 8 est du type nématique en hélice. On comprendra néanmoins que la cellule d'affichage à cristal liquide 8 peut être d'un autre type tel que super-nématique en hélice ou bien encore à alignement vertical.

Plus précisément, à la figure 2A, la cellule d'affichage à cristal liquide 8 et la cellule d'affichage OLED 30 sont toutes les deux éteintes. La cellule d'affichage à cristal liquide 8 est donc transparente. La lumière ambiante, désignée par la référence numérique 52, est polarisée linéairement par le polariseur absorbant 22. La lumière ambiante 52 subit ensuite une rotation de 90° lorsqu'elle traverse la cellule d'affichage à cristal liquide 8. Comme l'axe de transmission du polariseur réflectif 26 s'étend selon une direction perpendiculaire à la direction dans laquelle s'étend l'axe de transmission du polariseur absorbant 22, le polariseur réflectif 26 laisse passer sans modification la lumière ambiante 52 qui se propage en direction de la cellule d'affichage OLED 30. Avant de pénétrer dans la cellule d'affichage OLED 30, la lumière ambiante 52 est polarisée circulairement par le polariseur circulaire 46. Finalement, la lumière ambiante 52 traverse la cellule d'affichage OLED 30 dans laquelle elle se réfléchit sur l'électrode inférieure réfléchissante 42. Après réflexion sur l'électrode inférieure réfléchissante 42, le sens de rotation de la polarisation circulaire de la lumière est inversé, de sorte que la lumière est absorbée par le polariseur circulaire 46. L'ensemble d'affichage 1 apparaît ainsi noir au regard de l'observateur 4.

A la figure 2B, la cellule d'affichage à cristal liquide 8 est désactivée, tandis que la cellule d'affichage OLED 30 est activée. La cellule d'affichage à cristal liquide 8 est donc transparente et laisse passer la lumière émise par la cellule d'affichage OLED 30.

Plus précisément, la lumière ambiante 52, polarisée linéairement par le polariseur absorbant 22, subit une rotation de 90° lorsqu'elle traverse la cellule d'affichage à cristal liquide réflective 8, puis est transmise sans modification par le polariseur réflectif 26 dont l'axe de transmission est perpendiculaire à l'axe de transmission du polariseur absorbant 22. La lumière ambiante 52 est ensuite polarisée circulairement par le polariseur circulaire 46 qui la transmet sans absorption étant donné que l'axe de transmission du polariseur absorbant 48 est orienté parallèlement à l'axe de transmission du polariseur réflectif 26. Finalement, la lumière ambiante 52 pénètre dans la cellule d'affichage OLED 30. Dans la cellule d'affichage OLED 30, la lumière ambiante 52 est réfléchie par l'électrode inférieure transparente 42. Au moment de la réflexion, le sens de rotation de la polarisation circulaire de la lumière s'inverse de sorte que, lorsque la lumière traverse à nouveau le polariseur circulaire 46, elle est absorbée par ce dernier. D'autre part, la moitié de la lumière émise par la cellule d'affichage OLED 30 est absorbée par le polariseur absorbant 48, tandis que l'autre moitié de la lumière, polarisée linéairement, traverse tout d'abord le polariseur réflectif 26 sans modification puisque l'axe de transmission du polariseur réflectif 26 est orienté parallèlement à l'axe de transmission du polariseur absorbant 48 appartenant au polariseur circulaire 46. En traversant la cellule d'affichage à cristal liquide 8, la lumière polarisée subit une rotation de 90°, de sorte que sa direction de polarisation se retrouve finalement parallèle à l'axe de transmission du polariseur absorbant 22 qu'elle traverse sans être absorbée. Les informations affichées apparaissent ainsi en clair sur un fond sombre.

A la figure 2C, la cellule d'affichage à cristal liquide 8 est activée en mode réflectif et la cellule d'affichage OLED 30 est éteinte. La cellule d'affichage à cristal liquide 8 réfléchit donc la lumière ambiante 52, de sorte que les informations qu'elle affiche apparaissent en clair sur un fond sombre procuré par la cellule d'affichage OLED 30. Le contraste entre les pixels clairs de la cellule d'affichage à cristal liquide 8 et le fond noir de la cellule d'affichage OLED 30 permet d'afficher les informations de façon très lisible.

Plus précisément, dans les zones de la cellule d'affichage à cristal liquide 8 qui ne sont pas commutées, la lumière ambiante 52, polarisée linéairement par le polariseur absorbant 22, subit une rotation de 90° lorsqu'elle traverse la cellule d'affichage à cristal liquide 8, puis est transmise sans modification par le polariseur réflectif 26 dont l'axe de transmission est perpendiculaire à l'axe de transmission du polariseur absorbant 22. La lumière ambiante 52 est ensuite polarisée circulairement par le polariseur circulaire 46 qui la transmet sans absorption étant donné que l'axe de transmission du polariseur absorbant 48 est orienté parallèlement à l'axe de transmission du polariseur réflectif 26. Finalement, la lumière ambiante 52 pénètre dans la cellule d'affichage OLED 30 où elle est réfléchie par l'électrode inférieure transparente 42. A ce moment-là, le sens de rotation de la polarisation circulaire s'inverse, de sorte que lorsque la lumière traverse à nouveau le polariseur circulaire 46, elle est absorbée par ce dernier. D'autre part, dans les zones de la cellule d'affichage à cristal liquide 8 qui sont commutées, la lumière ambiante 52, après avoir été polarisée linéairement par le polariseur absorbant 22, traverse la cellule d'affichage à cristal liquide 8 sans modification, de sorte que la direction de polarisation de la lumière ambiante 52 se retrouve perpendiculaire à l'axe de transmission du polariseur réflectif 26 et donc parallèle à l'axe de réflexion de ce même polariseur 26. Par conséquent, la lumière ambiante 52 est réfléchie par le polariseur réflectif 26 en direction de la cellule d'affichage à cristal liquide 8. Dans les zones de la cellule d'affichage à cristal liquide 8 qui sont commutées, les molécules de cristal liquide ne modifient pas la direction de polarisation de la lumière ambiante 52 lorsque celle-ci traverse une nouvelle fois la cellule d'affichage à cristal liquide 8, de sorte que la lumière ambiante 52 n'est pas absorbée par le polariseur absorbant 22 lors de son trajet retour, ce qui permet de réaliser le mode d'affichage réflectif de l'ensemble d'affichage 1.

A la figure 2D, la cellule d'affichage à cristal liquide 8 est activée en mode réflectif et la cellule d'affichage OLED 30 est allumée. Dans ce cas, la lumière émise par la cellule d'affichage OLED 30 est absorbée par le polariseur absorbant 22 dans les zones actives de la cellule d'affichage à cristal liquide 8 où sont affichées des informations. Plus précisément, la lumière ambiante 52 est polarisée linéairement par le polariseur absorbant 22 puis traverse sans modification les zones de la cellule d'affichage à cristal liquide 8 qui sont commutées. Comme l'axe de transmission du polariseur absorbant 22 est perpendiculaire à l'axe de transmission du polariseur réflectif 26, la lumière ambiante 52 est réfléchie par le polariseur réflectif 26 puis traverse à nouveau sans modification les zones commutées de la cellule d'affichage à cristal liquide 8. Finalement, la lumière ambiante 52 traverse le polariseur absorbant 22 sans être absorbée et est perceptible par l'observateur 4, ce qui permet à la cellule d'affichage à cristal liquide 8 d'afficher les informations en mode réflectif. Quant au restant de la lumière ambiante 52, il est polarisé linéairement par le polariseur absorbant 22, puis traverse les zones non commutées de la cellule d'affichage à cristal liquide 8. Durant cette traversée, la direction de polarisation de la lumière ambiante 52 est tournée de 90°, de sorte que lorsque la lumière émerge de la cellule d'affichage à cristal liquide 8, sa direction de polarisation est parallèle à l'axe de transmission du polariseur réflectif 26. La lumière traverse alors le polariseur réflectif 26 sans modification, puis est polarisée circulairement par le polariseur circulaire 46. La lumière ambiante 52 pénètre ensuite dans la cellule d'affichage OLED 30 où elle est réfléchie par l'électrode inférieure transparente 42. A ce moment-là, le sens de rotation de la polarisation circulaire s'inverse, de sorte que lorsque la lumière traverse à nouveau le polariseur circulaire 46, elle est absorbée par ce dernier. D'autre part, la moitié de la lumière émise par la cellule d'affichage OLED 30 est absorbée par le polariseur absorbant 48, tandis que l'autre moitié de la lumière émise par la cellule d'affichage OLED 30 traverse le polariseur absorbant 48 en étant polarisée linéairement, puis traverse le polariseur réflectif 26 sans modification dans la mesure où l'axe de transmission du polariseur réflectif 26 est parallèle à l'axe de transmission du polariseur absorbant 48. Dans les zones de la cellule d'affichage à cristal liquide 8 qui sont activées, la lumière passe sans modification, de sorte qu'elle est absorbée par le polariseur absorbant 22 car sa direction de polarisation est perpendiculaire à l'axe de transmission du polariseur absorbant 22. Par contre, dans les zones de la cellule d'affichage à cristal liquide 8 qui ne sont pas activées, la direction de polarisation de la lumière est tournée de 90°, de sorte que cette fraction de lumière traverse le polariseur absorbant 22 sans être absorbée et est perceptible par l'observateur 4.

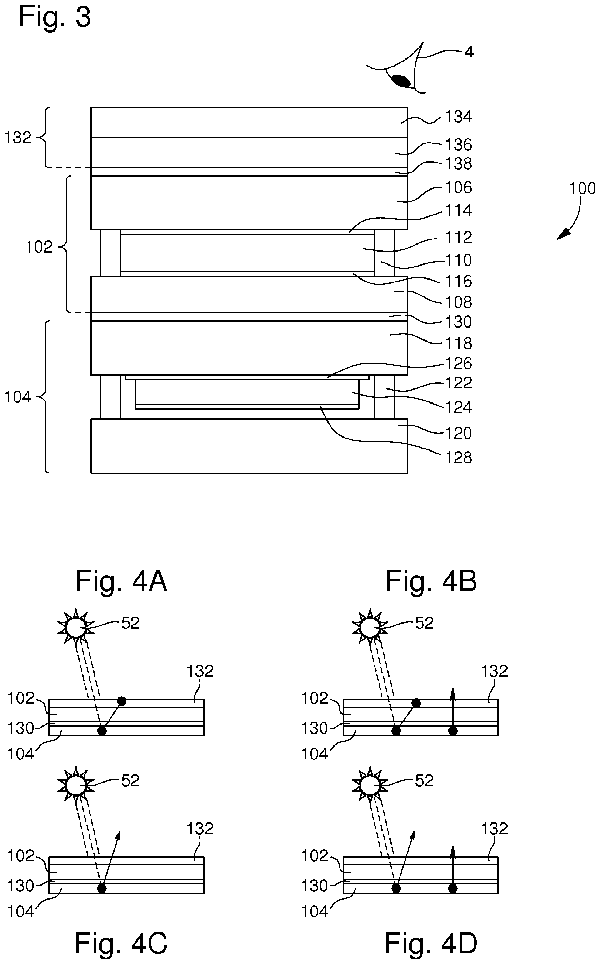

La figure 3 est une vue en coupe d'une variante de réalisation de l'ensemble d'affichage 1 selon l'invention illustré à la figure 1. Désigné dans son ensemble par la référence numérique générale 100, l'ensemble d'affichage illustré à la figure 3 comprend une cellule d'affichage à cristal liquide 102 disposée au-dessus d'une cellule d'affichage OLED 104. La cellule d'affichage à cristal liquide 102 est une cellule à simple polariseur dont les cristaux liquides sont alignés verticalement. Cette cellule d'affichage à cristal liquide 102 comprend un substrat avant 106 disposé du côté de l'observateur 4 et un substrat arrière 108 qui s'étend parallèlement à et à distance du substrat avant 106. Les substrats avant 106 et arrière 108 sont réunis entre eux par un cadre de scellement 110 qui délimite un volume clos pour le confinement de cristaux liquides 112 dont l'alignement est vertical. Des électrodes transparentes 114 sont ménagées sur la face inférieure du substrat avant 106 et des contre-électrodes transparentes 116 sont ménagées sur la face supérieure du substrat arrière 108.

La cellule d'affichage OLED 104 comprend un substrat 118 transparent réalisé en verre ou en un matériau plastique et un capot d'encapsulation 120 qui s'étend parallèlement à et à distance du substrat 118. Le substrat 118 et le capot d'encapsulation 120 sont réunis entre eux par un cadre de scellement 122 qui délimite un volume clos à l'abri de l'air et de l'humidité pour le confinement d'un empilement de couches électroluminescentes 124. Une électrode supérieure transparente 126 et une électrode inférieure réfléchissante 128 sont structurées de part et d'autre de l'empilement des couches électroluminescentes 124.

La cellule d'affichage à cristal liquide 102 est, par rapport à l'observateur 4, disposée au-dessus de la cellule d'affichage OLED 104. De préférence, la cellule d'affichage à cristal liquide 102 est collée sur la cellule d'affichage OLED 104 au moyen d'une couche adhésive 130 formée d'un adhésif en film ou d'une couche de colle liquide. La colle utilisée pour solidariser la cellule d'affichage à cristal liquide 102 sur la cellule d'affichage OLED 104 peut être transparente ou légèrement diffusante selon que l'on cherche à obtenir une réflexion spéculaire, respectivement diffuse.

Enfin, un polariseur circulaire 132 formé d'un polariseur absorbant 134 et d'une lame quart d'onde 136 est solidarisé sur la cellule d'affichage à cristal liquide 102 au moyen d'une couche adhésive 138 transparente.

De manière générale, la lumière ambiante est polarisée circulairement en passant à travers l'ensemble formé par le polariseur absorbant 134 et la lame quart d'onde 136. Au repos, les cristaux liquides ne modifient pas la polarisation de la lumière. Ainsi, la lumière polarisée circulairement se propage à travers la cellule d'affichage à cristal liquide 102 et la cellule d'affichage OLED 104 et se réfléchit sur l'électrode inférieure réfléchissante 128. Au moment de sa réflexion sur l'électrode inférieure réfléchissante 128, le sens de rotation de la polarisation circulaire de la lumière s'inverse, de sorte que lorsque la lumière traverse à nouveau le polariseur circulaire 132, elle est absorbée par le polariseur absorbant 134. L'ensemble d'affichage 100 apparaît ainsi noir.

Lorsqu'un champ électrique est appliqué à des électrodes sélectionnées de la cellule d'affichage à cristal liquide 102, les cristaux liquides se réorientent et modifient la polarisation de la lumière, de sorte que cette polarisation circulaire devient linéaire au moment de sa réflexion sur l'électrode inférieure réfléchissante 128 de la cellule d'affichage OLED 104. La lumière réfléchie par l'électrode inférieure réfléchissante 128 n'est ainsi pas absorbée par le polariseur absorbant 134 lors de son trajet retour et permet de réaliser le mode réflectif de l'ensemble d'affichage 100.

Les figures 4A à 4D illustrent schématiquement le mode de fonctionnement de l'ensemble d'affichage 100 illustré à la figure 3 selon que la cellule d'affichage à cristal liquide 102 ou la cellule d'affichage OLED 104 est en service ou non. Plus précisément, à la figure 4A, la cellule d'affichage à cristal liquide 102 et la cellule d'affichage OLED 104 sont toutes les deux éteintes. La cellule d'affichage à cristal liquide 102 est donc transparente et ne modifie pas la polarisation de la lumière ambiante 52. Polarisée circulairement par le polariseur circulaire 132, la lumière ambiante 52 traverse sans modification la cellule d'affichage à cristal liquide 102 et la cellule d'affichage OLED 104 avant de se réfléchir sur l'électrode inférieure réfléchissante 128. Au moment de sa réflexion sur l'électrode inférieure réfléchissante 128, le sens de rotation de la polarisation circulaire de la lumière s'inverse, de sorte que lorsque la lumière traverse à nouveau le polariseur circulaire 132, elle est absorbée. L'ensemble d'affichage 100 apparaît ainsi noir.

A la figure 4B, la cellule d'affichage à cristal liquide 102 est désactivée, tandis que la cellule d'affichage OLED 104 est activée. Polarisée circulairement par le polariseur circulaire 132, la lumière ambiante 52 traverse sans modification la cellule d'affichage à cristal liquide 102 et la cellule d'affichage OLED 104 avant d'être réfléchie par l'électrode inférieure réfléchissante 128. A ce moment-là, le sens de rotation de la polarisation circulaire de la lumière s'inverse de sorte que, lorsque la lumière traverse à nouveau le polariseur circulaire 132, elle est absorbée par ce dernier. Par contre, la lumière émise par la cellule d'affichage OLED 104 traverse la cellule d'affichage à cristal liquide 102 et le polariseur circulaire 104, de sorte qu'elle est perceptible par l'observateur 4. Les informations affichées par la cellule d'affichage OLED 104 s'affichent donc sur un fond sombre.

A la figure 4C, la cellule d'affichage à cristal liquide 102 est activée, tandis que la cellule d'affichage OLED 104 est éteinte. Dans les zones de la cellule d'affichage à cristal liquide 102 qui ne sont pas commutées, la lumière ambiante 52 est polarisée circulairement par le polariseur circulaire 132, puis traverse sans modification la cellule d'affichage à cristal liquide 102 et la cellule d'affichage OLED 104 avant d'être réfléchie par l'électrode inférieure réfléchissante 128. A ce moment-là, le sens de rotation de la polarisation circulaire s'inverse, de sorte que lorsque la lumière traverse à nouveau le polariseur circulaire 132, elle est absorbée par ce dernier. Dans les zones de la cellule d'affichage à cristal liquide 102 qui sont commutées, les molécules de cristal liquide modifient la polarisation circulaire de la lumière ambiante 52, de sorte que cette polarisation circulaire devient linéaire au moment de la réflexion de la lumière ambiante 52 sur l'électrode inférieure réfléchissante 128 de la cellule d'affichage OLED 104. La lumière réfléchie par l'électrode inférieure réfléchissante 128 n'est ainsi pas absorbée par le polariseur absorbant 134 lors de son trajet retour, ce qui permet de réaliser le mode réflectif de l'ensemble d'affichage 100.

A la figure 4D, la cellule d'affichage à cristal liquide 102 et la cellule d'affichage OLED 104 sont toutes deux activées. Dans les zones de la cellule d'affichage à cristal liquide 102 qui sont commutées, la lumière ambiante 52 réfléchie par l'électrode inférieure réfléchissante 128 n'est pas absorbée par le polariseur absorbant 134 et est perceptible par l'observateur 4, ce qui permet à la cellule d'affichage à cristal liquide 102 d'afficher les informations en mode réflectif. D'autre part, la lumière émise par la cellule d'affichage OLED 104 traverse la cellule d'affichage à cristal liquide 102 et le polariseur circulaire 132, de sorte qu'elle est perceptible par l'observateur 4.

Il est important de noter que d'autres modes d'alignement des molécules de cristal liquide tels que nématique en hélice ou super-nématique en hélice sont également envisageables pour la réalisation de l'ensemble d'affichage 100 selon l'invention illustré à la figure 3.

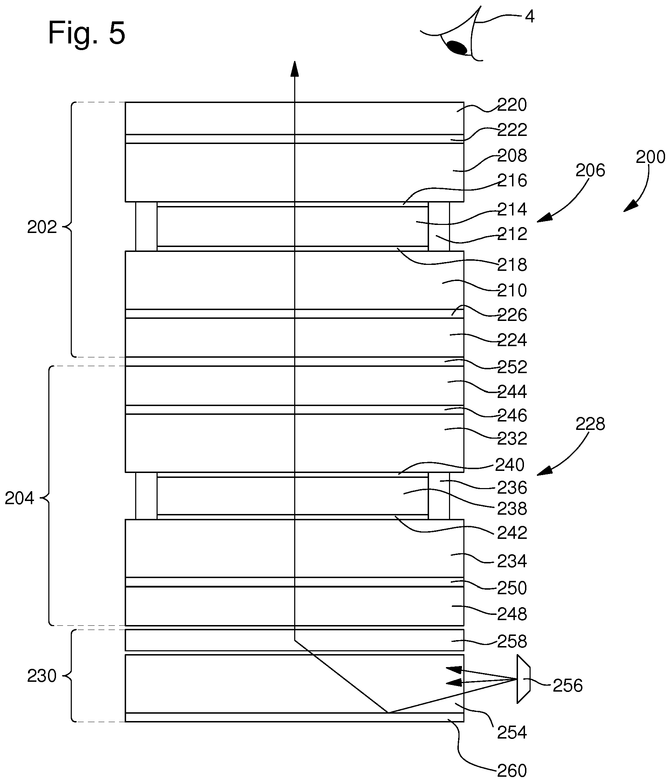

La figure 5 est une vue en coupe d'un second mode de réalisation d'un ensemble d'affichage selon l'invention. Désigné dans son ensemble par la référence numérique générale 200, cet ensemble d'affichage comprend un premier dispositif d'affichage réflectif 202 situé du côté de l'observateur 4, et un second dispositif d'affichage émissif 204 disposé sous le premier dispositif d'affichage réflectif 202.

Conformément à l'invention, le premier dispositif d'affichage réflectif 202 qui est réflectif dans un premier état de commutation et qui est transmissif dans un second état de commutation comprend une cellule d'affichage à cristal liquide supérieure 206. Toutes les phases des cristaux liquides telles que nématique en hélice, super-nématique en hélice ou bien encore à alignement vertical peuvent être envisagées. De même, tous les types d'adressage tels qu'adressage direct, adressage par matrice active ou adressage multiplexé d'une matrice passive peuvent être envisagés.

La cellule d'affichage à cristal liquide supérieure 206 comprend un substrat avant 208 situé du côté de l'observateur 4, et un substrat arrière 210 qui s'étend parallèlement à et à distance du substrat avant 208. Ces deux substrats avant 208 et arrière 210 sont réalisés en un matériau transparent tel que du verre ou du plastique. Ils sont réunis entre eux par un cadre de scellement 212 qui délimite un volume clos pour le confinement d'un cristal liquide 214 dont les propriétés optiques sont modifiées par application d'une tension appropriée à un point de croisement considéré entre des électrodes 216 ménagées sur une face inférieure du substrat avant 208 et des contre-électrodes 218 ménagées sur une face supérieure du substrat arrière 210. Les électrodes 216 et les contre-électrodes 218 sont réalisées en un matériau transparent électriquement conducteur tel que de l'oxyde d'indium-étain ou de l'oxyde d'indium-zinc.

Un polariseur absorbant 220 est collé sur une face supérieure du substrat avant 208 au moyen d'une couche adhésive transparente 222. Cette couche adhésive transparente 222 peut être formée d'un adhésif en film ou d'une couche de colle liquide. Quant au polariseur absorbant 220, il peut-être, par exemple, du type à iodine ou à colorant. Un polariseur réflectif 224 est collé sur une face inférieure du substrat arrière 210 au moyen d'une couche adhésive 226. Cette couche adhésive 226 peut être transparente ou légèrement diffusante selon que l'on recherche une réflexion spéculaire, respectivement diffuse. Le polariseur réflectif 224 peut être du type à grille de fils, mieux connu sous sa dénomination anglo-saxonne Wire Grid Polarizer. Il peut également s'agir d'un polariseur du type Dual Brightness Enhancement Film (DBEF) ou du type APF. Ces polariseurs sont tous deux commercialisés par la société américaine 3M®.

Toujours selon l'invention, le second dispositif d'affichage émissif 204 comprend une cellule d'affichage à cristal liquide inférieure 228 de type transmissif associée à un dispositif de rétroéclairage 230. La cellule d'affichage à cristal liquide inférieure 228 peut être commutée entre un mode transmissif et un mode absorbant. Toutes les phases des cristaux liquides tels que nématique en hélice, super-nématique en hélice ou bien encore à alignement vertical peuvent être envisagées. De même, tout type d'adressage tel qu'adressage direct, adressage par matrice active ou passive peut être envisagé. La cellule d'affichage à cristal liquide inférieure 228 est optimisée pour laisser passer un maximum de lumière provenant du dispositif de rétroéclairage 230 en mode transmissif, et bloquer la lumière au mieux à l'état absorbant, procurant ainsi un excellent contraste.

Plus précisément, la cellule d'affichage à cristal liquide inférieure 228 comprend un substrat avant 232 dirigé du côté de l'observateur 4 et un substrat arrière 234 qui s'étend parallèlement à et à distance du substrat avant 232. Les substrats avant 232 et arrière 234 sont réalisés en un matériau transparent tel que du verre ou du plastique. Ils sont réunis entre eux par un cadre de scellement 236 qui délimite un volume clos pour le confinement d'un cristal liquide 238. Des électrodes 240 sont ménagées sur une face inférieure du substrat avant 232 et des contre-électrodes 242 sont ménagées sur une face supérieure du substrat arrière 234. Ces électrodes 240 et contre-électrodes 242 sont réalisées en un matériau transparent électriquement conducteur tel que de l'oxyde d'étain-indium, mieux connu sous sa dénomination anglo-saxonne Indium-Tin Oxyde ou ITO.

Un polariseur absorbant 244 est collé sur une face supérieure du substrat avant 232 au moyen d'une couche adhésive transparente 246. Cette couche adhésive transparente 246 peut être formée d'un adhésif en film ou d'une couche de colle liquide. Un polariseur absorbant 248 est collé sur une face inférieure du substrat arrière 234 au moyen d'une couche adhésive transparente 250.

Conformément à l'invention, la cellule d'affichage à cristal liquide supérieure 206 est disposée au-dessus de la cellule d'affichage à cristal liquide inférieure 228. De préférence, la cellule d'affichage à cristal liquide supérieure 206 est collée sur la cellule d'affichage à cristal liquide inférieure 228 par l'intermédiaire d'une couche adhésive transparente 252. De la sorte, on évite les problèmes de réflexions parasites entre les deux cellules d'affichage qui dégraderaient la qualité optique de l'ensemble d'affichage 200.

Enfin, le dispositif de rétroéclairage 230 est placé sous la cellule d'affichage à cristal liquide inférieure 228. Ce dispositif de rétroéclairage 230 comprend un guide de lumière 254 dans lequel est injectée la lumière émise par une ou plusieurs sources de lumière 256. Le guide de lumière 254 est placé entre un film réfléchissant 260 placé sous le guide de lumière 254 et un film ou une combinaison de films d'homogénéisation de l'éclairage 258, par exemple un film diffuseur et/ou des films prismatiques du type BEF (Brightness Enhancement Film) ou encore un polariseur réflectif du type DBEF (Dual Brightness Enhancement Film) ou APF. Grâce au film réfléchissant 260 et à des structures d'extraction notamment ménagées dans la surface supérieure du guide de lumière 254, la lumière émise par la source de lumière 256 et injectée dans le guide de lumière 254 est extraite de ce dernier vers le haut et traverse successivement la cellule d'affichage à cristal liquide inférieure 228 et la cellule d'affichage à cristal liquide supérieure 206.

Selon une caractéristique de l'invention, l'axe de transmission du polariseur réflectif 224 de la cellule d'affichage à cristal liquide supérieure 206 est parallèle à l'axe de transmission du polariseur absorbant 244 de la cellule d'affichage à cristal liquide inférieure 228. Selon une variante, le polariseur absorbant 244 de la cellule d'affichage à cristal liquide inférieure 228 peut être omis, ce qui permet de réaliser un gain en termes d'encombrement et de coût de fabrication. Toutefois, l'utilisation de ce polariseur absorbant 244 a l'avantage d'assurer un meilleur contraste de l'affichage en mode émissif.

Il va de soi que la présente invention n'est pas limitée aux modes de réalisation qui viennent d'être décrits et que diverses modifications et variantes simples peuvent être envisagées par l'homme du métier sans sortir du cadre de l'invention tel que défini par les revendications annexées.

### Nomenclature

Ensemble d'affichage 1
Premier dispositif d'affichage réflectif 2
Observateur 4
Second dispositif d'affichage émissif 6
Cellule d'affichage à cristal liquide 8
Substrat avant 10
Substrat arrière 12
Cadre de scellement 14
Cristal liquide 16
Electrodes transparentes 18
Contre-électrodes transparentes 20
Polariseur absorbant 22
Couche adhésive 24
Polariseur réflectif 26
Couche adhésive 28
Cellule d'affichage émissive 30
Substrat 32
Capot d'encapsulation 34
Cadre de scellement 36
Couches électroluminescentes 38
Electrode supérieure transparente 40
Electrode inférieure réfléchissante 42
Couche adhésive transparente 44
Polariseur circulaire 46
Polariseur absorbant 48
Lame quart d'onde 50
Couche adhésive 51
Lumière ambiante 52
Ensemble d'affichage 100
Cellule d'affichage à cristal liquide 102
Cellule d'affichage OLED 104
Substrat avant 106
Substrat arrière 108
Cadre de scellement 110
Cristaux liquides 112
Electrodes transparentes 114
Contre-électrodes transparentes 116
Substrat 118
Capot d'encapsulation 120
Cadre de scellement 122
Couches électroluminescentes 124
Electrode supérieure transparente 126
Electrode inférieure réfléchissante 128
Couche adhésive 130
Polariseur circulaire 132
Polariseur absorbant 134
Lame quart d'onde 136
Couche adhésive 138
Ensemble d'affichage 200
Premier dispositif d'affichage réflectif 202
Second dispositif d'affichage émissif 204
Cellule d'affichage à cristal liquide supérieure 206
Substrat avant 208
Substrat arrière 210
Cadre de scellement 212
Cristal liquide 214
Electrode 216
Contre-électrode 218
Polariseur absorbant 220
Couche adhésive transparente 222
Polariseur réflectif 224
Couche adhésive 226
Cellule d'affichage à cristal liquide inférieure 228
Dispositif de rétroéclairage 230
Substrat avant 232
Substrat arrière 234
Cadre de scellement 236
Cristal liquide 238
Electrode 240
Contre-électrode 242
Polariseur absorbant 244
Couche adhésive transparente 246
Polariseur absorbant 248
Couche adhésive transparente 250
Couche adhésive transparente 252
Guide de lumière 254
Source de lumière 256
Film d'homogénéisation de l'éclairage 258
Film réfléchissant 260

## Revendications

1. Ensemble d'affichage pour un objet portable comprenant une cellule d'affichage à cristal liquide (8) de type nématique en hélice, super-nématique en hélice ou bien à alignement vertical agencée pour commuter entre un état réflectif lorsqu'elle est activée et un état transparent lorsqu'elle est au repos, la cellule d'affichage à cristal liquide réflective (8) étant disposée entre un polariseur supérieur absorbant (22) et un polariseur inférieur réflectif (26), un dispositif d'affichage émissif (6) étant disposé sous la cellule d'affichage à cristal liquide (8), ce dispositif d'affichage émissif (6) comprenant une cellule d'affichage émissive (30) à diodes organiques électroluminescentes agencée pour commuter entre un état actif où elle émet de la lumière et un état de repos où elle n'émet pas de lumière, **caractérisé en ce qu'**un polariseur circulaire (46) formé d'un polariseur absorbant (48) et d'une lame quart d'onde (50) est disposé entre le polariseur inférieur réflectif (26) et la cellule d'affichage émissive (30), le polariseur inférieur réflectif (26) et le polariseur absorbant (48) possédant chacun un axe de transmission, ces axes de transmission étant parallèles entre eux.

2. Ensemble d'affichage selon la revendication 1, **caractérisé en ce que** la cellule d'affichage à cristal liquide (8) est collée sur le dispositif d'affichage émissif (6) au moyen d'une couche adhésive (44).

3. Ensemble d'affichage selon la revendication 2, **caractérisé en ce que** la couche adhésive (44) est formée d'un adhésif en film ou d'une couche de colle liquide.

4. Ensemble d'affichage pour un objet portable comprenant une cellule d'affichage à cristal liquide (102) de type à alignement vertical agencée pour commuter entre un état réflectif lorsqu'elle est activée et un état transparent lorsqu'elle est au repos, un dispositif d'affichage émissif (104) étant disposé sous la cellule d'affichage à cristal liquide (102), le dispositif d'affichage émissif (104) comprenant une cellule d'affichage émissive (104) à diodes organiques électroluminescentes agencée pour commuter entre un état actif où elle émet de la lumière et un état de repos où elle n'émet pas de lumière, **caractérisé en ce qu'**un polariseur circulaire (132) formé d'un polariseur absorbant (134) et d'une lame quart d'onde (136) est disposé sur une face avant de la cellule d'affichage à cristal liquide réflective (102), et **en ce que** la cellule d'affichage émissive (104) à diodes organiques électroluminescentes comprend une électrode inférieure réfléchissante (128).

5. Ensemble d'affichage selon la revendication 4, **caractérisé en ce que** la cellule d'affichage à cristal liquide (102) est collée sur le dispositif d'affichage émissif (104) au moyen d'une couche adhésive (130).

6. Ensemble d'affichage selon la revendication 5, **caractérisé en ce que** la couche adhésive (130) est formée d'un adhésif en film ou d'une couche de colle liquide.

7. Ensemble d'affichage pour un objet portable comprenant une cellule d'affichage à cristal liquide (206) de type nématique en hélice, super-nématique en hélice ou bien à alignement vertical agencée pour commuter entre un état réflectif lorsqu'elle est activée et un état transparent lorsqu'elle est au repos, un dispositif d'affichage émissif (204) étant disposé sous la cellule d'affichage à cristal liquide (206), la cellule d'affichage à cristal liquide réflective (206) étant disposée entre un polariseur supérieur absorbant (220) disposé sur une face supérieure de la cellule d'affichage à cristal liquide réflective (206) et un polariseur inférieur réflectif (224) disposé sur la face inférieure de la cellule d'affichage à cristal liquide réflective (206), le dispositif d'affichage émissif (204) comprenant une cellule d'affichage à cristal liquide inférieure (228) agencée pour commuter entre un état dans lequel elle est absorbante et un état dans lequel elle laisse passer la lumière émise par un dispositif de rétroéclairage (230) disposé sous la cellule d'affichage à cristal liquide (228), **caractérisé en ce qu'**un polariseur absorbant (244) est disposé sur une face supérieure de la cellule d'affichage à cristal liquide inférieure (228), et **en ce qu'**un polariseur absorbant (248) est collé sur une face inférieure de la cellule d'affichage à cristal liquide inférieure (228), le polariseur inférieur réflectif (224) et le polariseur absorbant (244) disposé sur la face supérieure de la cellule d'affichage à cristal liquide inférieure (228) possédant chacun un axe de transmission, ces axes de transmission étant parallèles entre eux.

8. Ensemble d'affichage selon la revendication 7, **caractérisé en ce que** la cellule d'affichage à cristal liquide (206) est collée sur la cellule d'affichage à cristal liquide inférieure (228) au moyen d'une couche adhésive (252).

9. Ensemble d'affichage selon la revendication 8, **caractérisé en ce que** la couche adhésive (252) est formée d'un adhésif en film ou d'une couche de colle liquide.

## Patentansprüche

1. Anzeigeeinheit für einen tragbaren Gegenstand, umfassend eine Flüssigkristall-Anzeigezelle (8) des verdrillten nematischen Typs, des verdrillten supernematischen Typs oder mit vertikaler Ausrichtung, die dafür ausgelegt ist, zwischen einem reflektierenden Zustand bei Aktivierung und einem transparenten Zustand im Ruhezustand zu wechseln, wobei die reflektierende Flüssigkristall-Anzeigezelle (8) zwischen einem absorbierenden oberen Polarisator (22) und einem reflektierenden unteren Polarisator (26) angeordnet ist, wobei unter der Flüssigkristall-Anzeigezelle (8) eine emittierende Anzeigevorrichtung (6) angeordnet ist, wobei diese emittierende Anzeigevorrichtung (6) eine emittierende Anzeigezelle (30) mit organischen Leuchtdioden umfasst, die angeordnet ist, um zwischen einem aktiven Zustand, in dem sie Licht emittiert, und einem Ruhezustand, in dem sie kein Licht emittiert, zu wechseln, wobei die Anzeigeeinheit ferner einen Zirkularpolarisator (46) umfasst, der aus einem absorbierenden Polarisator (48) und einer Lambda-Viertel-Platte (50) gebildet ist und zwischen dem reflektierenden unteren Polarisator (26) und der emittierenden Anzeigezelle (30) angeordnet ist, wobei der reflektierende untere Polarisator (26) und der absorbierende Polarisator (48) jeweils eine Durchlassachse besitzen und diese Durchlassachsen zueinander parallel sind.

2. Anzeigeeinheit nach Anspruch 1, **dadurch gekennzeichnet, dass** die Flüssigkristall-Anzeigezelle (8) mittels einer Klebeschicht (44) mit der emittierenden Anzeigevorrichtung (6) verklebt ist.

3. Anzeigeeinheit nach Anspruch 2, **dadurch gekennzeichnet, dass** die Klebeschicht (44) aus einem filmartigen Klebstoff oder aus einer Flüssigklebeschicht gebildet ist.

4. Anzeigeeinheit für einen tragbaren Gegenstand, umfassend eine Flüssigkristall-Anzeigezelle (102) des Typs mit vertikaler Ausrichtung, die dafür ausgelegt ist, zwischen einem reflektierenden Zustand bei Aktivierung und einem transparenten Zustand im Ruhezustand zu wechseln, wobei unter der Flüssigkristall-Anzeigezelle (102) eine emittierende Anzeigevorrichtung (104) angeordnet ist, wobei die emittierende Anzeigevorrichtung (104) eine emittierende Anzeigezelle (104) mit organischen Leuchtdioden umfasst, die angeordnet ist, um zwischen einem aktiven Zustand, in dem sie Licht emittiert, und einem Ruhezustand, in dem sie kein Licht emittiert, zu wechseln, wobei die Anzeigeeinheit ferner einen Zirkularpolarisator (132) umfasst, der aus einem absorbierenden Polarisator (134) und einer Lambda-Viertel-Platte (136) gebildet ist und auf einer Vorderseite der reflektierenden Flüssigkristall-Anzeigezelle (102) angeordnet ist, und dass die emittierende Anzeigezelle (104) mit organischen Leuchtdioden eine reflektierende untere Elektrode (128) umfasst.

5. Anzeigeeinheit nach Anspruch 4, **dadurch gekennzeichnet, dass** die Flüssigkristall-Anzeigezelle (102) mittels einer Klebeschicht (130) mit der emittierenden Anzeigevorrichtung (104) verklebt ist.

6. Anzeigeeinheit nach Anspruch 5, **dadurch gekennzeichnet, dass** die Klebeschicht (130) aus einem filmartigen Klebstoff oder aus einer Flüssigklebeschicht gebildet ist.

7. Anzeigeeinheit für einen tragbaren Gegenstand, umfassend eine Flüssigkristall-Anzeigezelle (206) des verdrillten nematischen Typs, des verdrillten supernematischen Typs oder mit vertikaler Ausrichtung, die dafür ausgelegt ist, zwischen einem reflektierenden Zustand bei Aktivierung und einem transparenten Zustand im Ruhezustand zu wechseln, wobei unter der Flüssigkristall-Anzeigezelle (206) eine emittierende Anzeigevorrichtung (204) angeordnet ist, wobei die reflektierende Flüssigkristall-Anzeigezelle (206) angeordnet ist zwischen einem absorbierenden oberen Polarisator (220), der auf einer Oberseite der reflektierenden Flüssigkristall-Anzeigezelle (206) angeordnet ist, und einem reflektierenden unteren Polarisator (224), der auf der Unterseite der reflektierenden Flüssigkristall-Anzeigezelle (206) angeordnet ist, wobei die emittierende Anzeigevorrichtung (204) eine untere Flüssigkristall-Anzeigezelle (228) umfasst, die angeordnet ist, um zwischen einem Zustand, in dem sie absorbierend ist, und einem Zustand, in dem sie das von der unter der Flüssigkristall-Anzeigezelle (228) angeordneten Hintergrundbeleuchtungsvorrichtung (230) emittierte Licht durchlässt, zu wechseln, wobei die Anzeigeeinheit weiterhin einen absorbierenden Polarisator (244) umfasst, der auf einer Oberseite der unteren Flüssigkristall-Anzeigezelle (228) angeordnet ist, und dass der absorbierende Polarisator (248) mit einer Unterseite der unteren Flüssigkristall-Anzeigezelle (228) verklebt ist, wobei der reflektierende untere Polarisator (224) und der absorbierende Polarisator (244), der auf der Oberseite der unteren Flüssigkristall-Anzeigezelle (228) angeordnet ist, jeweils eine Durchlassachse besitzen und diese Durchlassachsen zueinander parallel sind.

8. Anzeigeeinheit nach Anspruch 7, **dadurch gekennzeichnet, dass** die Flüssigkristall-Anzeigezelle (206) mittels einer Klebeschicht (252) mit der unteren Flüssigkristall-Anzeigezelle (228) verklebt ist.

9. Anzeigeeinheit nach Anspruch 8, **dadurch gekennzeichnet, dass** die Klebeschicht (252) aus einem filmartigen Klebstoff oder aus einer Flüssigklebeschicht gebildet ist.

## Claims

1. Display assembly for a portable object, said display assembly comprising a liquid crystal display cell (8) of the twisted nematic, super twisted nematic or vertically aligned type, said liquid crystal display cell being arranged to switch between a reflective state when activated and a transparent state when at rest, the reflective liquid crystal display cell (8) being disposed between an absorbent upper polarizer (22) and a reflective lower polarizer (26), an emissive display device (6) being disposed underneath the liquid crystal display cell (8), this emissive display device (6) comprising an emissive organic light-emitting diode display cell (30) arranged to switch between an active state wherein the display cell emits light and a rest state wherein the display cell does not emit light, the display assembly further comprising a circular polarizer (46) formed of an absorbent polarizer (48) and of a quarter-wave plate (50) disposed between the reflective lower polarizer (26) and the emissive display cell (30), the reflective lower polarizer (26) and the absorbent polarizer (48) each having an axis of transmission, these axes of transmission being parallel to each other.

2. Display assembly according to claim 1, **characterized in that** the liquid crystal display cell (8) is bonded on the emissive display device (6) by means of an adhesive layer (44).

3. Display assembly according to claim 2, **characterized in that** the adhesive layer (44) is formed of an adhesive film or a liquid adhesive layer.

4. Display assembly for a portable object, said display assembly comprising a liquid crystal display cell (102) of the vertically aligned type, said liquid crystal display cell being arranged to switch between a reflective state when activated and a transparent state when at rest, an emissive display device (104) being disposed underneath the liquid crystal display cell (102), the emissive display device (104) comprising an emissive organic light-emitting diode display cell (104) arranged to switch between an active state wherein the display cell emits light and a rest state wherein the display cell does not emit light, the display assembly further comprising a circular polarizer (132) formed of an absorbent polarizer (134) and of a quarter-wave plate (136) being disposed on a front face of the reflective liquid crystal display (102), and in that the emissive organic light-emitting diode display cell (104) includes a reflective lower electrode (128).

5. Display assembly according to claim 4, **characterized in that** the liquid crystal display cell (102) is bonded on the emissive display device (104) by means of an adhesive layer (130).

6. Display assembly according to claim 5, **characterized in that** the adhesive layer (130) is formed of an adhesive film or a liquid adhesive layer.

7. Display assembly for a portable object, said display assembly comprising a liquid crystal display cell (206) of the twisted nematic, super twisted nematic or vertically aligned type, said liquid crystal display cell being arranged to switch between a reflective state when activated and a transparent state when at rest, an emissive display device (204) being disposed underneath the liquid crystal display cell (206), the reflective liquid crystal display cell (206) being disposed between an upper absorbent polarizer (220) disposed on an upper face of the reflective liquid crystal display cell (206), and a lower reflective polarizer (224) disposed on a lower face of the reflective liquid crystal display cell (206), the emissive display device (204) comprising a lower liquid crystal display cell (228) arranged to switch between a state wherein the display cell is absorbent and a state wherein the display cell allows the light emitted by a backlight device (230) disposed underneath the liquid crystal display cell (228) to pass through, the display assembly further comprising an absorbent polarizer (244) disposed on an upper face of the lower liquid crystal display cell (228), and in that an absorbent polarizer (248) is bonded on a lower face of the lower liquid crystal display cell (228), the lower reflective polarizer (224) and the absorbent polarizer (244) arranged on the upper face of the lower liquid crystal display cell (228) each having an axis of transmission, these axes of transmission being parallel to each other.

8. Display assembly according to claim 7, **characterized in that** the liquid crystal display cell (206) is bonded on the lower liquid crystal display cell (228) by means of an adhesive layer (252).

9. Display assembly according to claim 8, **characterized in that** the adhesive layer (252) is formed of an adhesive film or a liquid adhesive layer.
